# EUROPEAN PATENT APPLICATION

(11) **EP 4 746 593 A1**
(43) Date of publication of application: **20.05.2026**
(21) Application number: 24212663.9
(22) Date of filing: 13.11.2024
(51) Int. Cl.: H05K 3/00, H05K 3/04, H05K 3/10, H05K 1/18

(54) **COMPONENT CARRIER WITH EMBEDDED TRACE HAVING LATERAL WALLS SLANTED INWARDLY BEGINNING FROM AN EXTERIOR SURFACE AND HAVING AN OPPOSING ROUNDED EDGE**

(71) Applicant: AT & S Austria Technologie & Systemtechnik Aktiengesellschaft, 8700 Leoben (AT)
(72) Inventor: STEINBERGER, Anke, 8792 St. Peter-Freienstein (AT); HAUSBERGER, Vera, 8700 Leoben (AT)
(74) Representative: Dilg, Haeusler, Schindelmann Patentanwaltsgesellschaft mbH

(57) **Abstract**

A component carrier (100) which comprises a stack (102) comprising at least one electrically insulating layer structure (104) and at least one electrically conductive layer structure (106), said at least one electrically conductive layer structure (106) comprising at least one trace (108) embedded in the at least one electrically insulating layer structure (104), said at least one trace (108) comprising, in a cross section, two lateral walls (110) slanted inwardly beginning from an exterior surface (112) where said embedded trace (108) is exposed with respect to the at least one electrically insulating layer structure (104), wherein the at least one trace (108) comprises, in the cross section, two sharp edges (114) at the exterior surface (112) and at least one rounded edge (116) at an opposed extremity.

## Description

### Field of the Invention

The invention relates to a component carrier, and to a method of manufacturing a component carrier.

### Technological Background

In the context of growing product functionalities of component carriers equipped with one or more components and increasing miniaturization of such components as well as a rising number of components to be connected to the component carriers such as printed circuit boards or component carriers, increasingly more powerful array-like components or packages having several components are being employed, which have a plurality of contacts or connections, with smaller and smaller spacing between these contacts. In particular, component carriers shall be mechanically robust and electrically reliable so as to be operable even under harsh conditions.

Conventional approaches of forming component carriers are still challenging.

### Summary of the Invention

There may be a need to form a compact and reliable component carrier.

According to an exemplary embodiment of the invention, a component carrier is provided which comprises a stack comprising at least one electrically insulating layer structure and at least one electrically conductive layer structure, said at least one electrically conductive layer structure comprising at least one trace embedded in the at least one electrically insulating layer structure, said at least one trace comprising, in a cross section (in particular in a cross section being perpendicular to a stack thickness direction), two lateral walls slanted inwardly beginning from an exterior surface where said embedded trace is exposed with respect to the at least one electrically insulating layer structure, wherein the at least one trace comprises, in the cross section, two sharp edges at the exterior surface and at least one rounded edge at an opposed extremity.

According to another exemplary embodiment of the invention, a method of manufacturing a component carrier is provided, wherein the method comprises forming a stack comprising at least one electrically insulating layer structure and at least one electrically conductive layer structure, forming said at least one electrically conductive layer structure with at least one trace embedded in the at least one electrically insulating layer structure, configuring said at least one trace so that it comprises, in a cross section (in particular in a cross section being perpendicular to a stack thickness direction), two lateral walls slanted inwardly beginning from an exterior surface where said embedded trace is exposed with respect to the at least one electrically insulating layer structure, and configuring said at least one trace so that it comprises, in the cross section, two sharp edges at the exterior surface and at least one rounded edge at an opposed extremity.

In the context of the present application, the term "component carrier" may particularly denote any support structure which is capable of accommodating one or more components thereon and/or therein for providing mechanical support and/or electrical connectivity and/or thermal connectivity. In other words, a component carrier may be configured as a mechanical and/or electronic and/or thermal carrier for components. A component carrier may comprise a laminated stack, such as a laminated layer stack. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat. Preferably, the plurality of layer structures are aligned parallel on top of each other. The stack may comprise at least one electrically conductive structure and at least one electrically insulating structure.

In the context of the present application, the term "layer structure" may particularly denote a continuous layer, a patterned layer or a plurality of nonconsecutive islands within a common plane, and it may perform the function of electrical conductivity and/or electrical insulation.

In the context of the present application, the term "trace" may particularly denote an elongate element of a horizontal electrically conductive layer structure. For instance, such an elongate element may be straight, curved and/or angled. An example of a horizontal trace element is a wiring within a horizontal plane. A trace of an electrically conductive layer structure may extend within a horizontal plane. A length of a trace may be at least five times of a height and/or a width of a trace.

In the context of the present application, the term "lateral wall slanted inwardly beginning from an exterior surface where an embedded trace is exposed with respect to the at least one electrically insulating layer structure" may particularly denote that directly from the exterior surface onwards, the opposing lateral walls of the trace taper inwardly without a vertical section at the exterior surface. In particular, the width of the trace may decrease along the stack thickness.

In the context of the present application, the term "sharp edge at an exterior surface where an embedded trace is exposed with respect to the at least one electrically insulating layer structure" may particularly denote the presence of a discontinuity between a horizontal exterior surface of the trace and the respective slanted lateral wall thereof. Such a discontinuity may be present at both opposing sides of the trace in its cross-sectional view. For example, the sharp edge may be visible in the cross-sectional view by a corner between two connected delimiting lines, one relating to the slanted lateral sidewall and the other one relating to the exterior surface. The exterior surface may have a horizontal appearance in a cross-sectional view. For instance, the angle between said two delimiting lines may be acute in an interior of the trace.

In the context of the present application, the term "rounded edge at an opposed extremity with respect to an exterior surface where an embedded trace is exposed with respect to the at least one electrically insulating layer structure" may particularly denote a curved continuous end region facing away from the sharp edges. The rounded edge(s) may be concave and free of a sharp edge.

In the context of the present application, the term "main surface of a body" may particularly denote one or more largest substantially planar surface area(s) of the body (for instance the stack). Usually, for instance substantially cuboid bodies may have two opposing main surfaces in the form of two horizontal surface areas on top and on bottom of the body. Thus, the main surface may be different from the sidewalls of the body.

According to an exemplary embodiment, a component carrier (such as a printed circuit board or an integrated circuit substrate) comprises a (preferably laminated) layer stack with one or more electrically conductive traces embedded in an electrically insulating layer structure thereof. When viewed in a cross section cut along a vertical plane, two sidewalls of the trace are slanted inwardly starting directly from an exterior surface of the trace where being exposed with respect to the trace-embedding electrically insulating layer structure. In said cross-sectional view and at the aforementioned exterior surface, the trace has two sharp edges opposing one or more rounded edges at the opposite extremity or end of the trace with regard to the exterior surface. A trace with such a geometrical shape may be the fingerprint of a manufacturing process in which a trench or recess is formed in the electrically insulating layer structure accommodating the trace by a laser shot while the laser is scanned along a trajectory of said trace. The fingerprint of such a laser formed trench or recess may be the rounded profile at the vertical extremities of said trench or recess, linked by two lateral walls slanted inwardly (in particular towards the closed bottom of the said trench or recess). Such a trench or recess may then be filled by an electrically conductive material (such as copper), for instance by plating. In particular, several of said traces which may be formed side-by-side in the electrically insulating layer structure may be filled with electrically conductive material simultaneously and with an intentional excess and overlap, before removing excessive or overlapping electrically conductive material to separate traces and thereby complete formation of said trace or traces. The fingerprint of the removal of the excessive or overlapping electrically conductive material to separate traces may be the two sharp edges at their exposure side at the respective electrically insulating layer structure main surface, due to the respective removal along a planar direction (in particular by routing, peeling, etc.). Such a trace manufacturing method and corresponding trace shape may lead to excellent properties in terms of fine line structuring, since extremely small line space ratios may be manufactured in such a way. It may be possible to firstly form adjacent traces (in particular very) close one to each other without taking too much into account of the resulting overlapping and/or bridging of the filled conductive structure. Said traces may be subsequently divided by the removal step, said removal step being also configured to precisely define the vertical thickness of the traces, the consequent horizontal width and respective distance among two adjacent traces. This may be achieved through the setting of the height of the planar removal with respect to a bottom extremity of the traces and/or the distance from the main surface of the respective electrically insulating layer structure opposed to a respective side where the trenches have been formed. Such traces may thus contribute therefore to the continuing trend of miniaturization of component carrier features.

### Detailed Description of Exemplary Embodiments

In the following, further exemplary embodiments of the component carrier and the method will be explained.

In an embodiment, a ratio between a maximum horizontal width and a vertical thickness of the at least one trace is in a range from 0.05 to 3, in particular in a range from 0.1 to 1. In particular, the ratio between a maximum horizontal width and a vertical thickness of the at least one trace is less than 1. Hence, the traces may be formed with an aspect ratio of larger than one or larger than two or more. By the use of the related manufacturing method, a higher design flexibility may be achieved, especially for traces having a width smaller than 5 µm. The mentioned figures may refer to a cross section perpendicular to the planar direction of the trace at the portion where the cross section intersects the trace.

In an embodiment, the at least one rounded edge continuously merges into the two slanted lateral walls. In particular due to the manufacturing method implying the formation of (each of the adjacent) the recess or trench, discontinuities may be avoided between trace and electrically insulating layer structure with the exception of the sharp edges at an interface to the planar exterior surface. For example, the rounded edge may define a tangent transition with the respective slanted lateral wall. No edge may result at the transition between the rounded edge and the slanted lateral walls. Since discontinuities may be avoided, (for example electrical) signal transmission may be enhanced and/or signal losses may be avoided.

In an embodiment, at least a section of the slanted lateral walls extends substantially straight. Such a substantially straight portion may be oblique rather than being vertical. Such slanted lateral walls may enable better adhesion to the adjacent electrically insulating layer structure, since the inclination of the slanted lateral wall enlarges the surface of the trace compared to lateral walls extending in stack thickness direction.

In an embodiment, the slanted lateral walls have an irregular shape which follows a principal direction, in particular a straight direction. For instance, such an irregular shape may be obtained by reinforcing beads or fibers (such as glass spheres or glass fibers) which may be included in the electrically insulating layer structure embedding the respective trace. Also reinforcing material not comprising glass may be possible, for example aluminium oxide, magnesium oxide, etc. When forming a laser trench, an interface between trench and electrically insulating layer structure may comprise ripples formed at least partially by reinforcing particles being not or not entirely removed by the laser treatment.

In an embodiment, a maximum horizontal width of the at least one trace is in a range from 0.5 µm to 4 µm, in particular in a range from 1.5 µm and 2.5 µm. Highly advantageously, the described manufacturing architecture and correspondingly obtained trace configuration may be perfectly compatible with demanding fine-line structuring requirements. In particular, the line space ratio L/S of a trace may be not more than 4 µm/4 µm, preferably not more than 3 µm/3 µm.

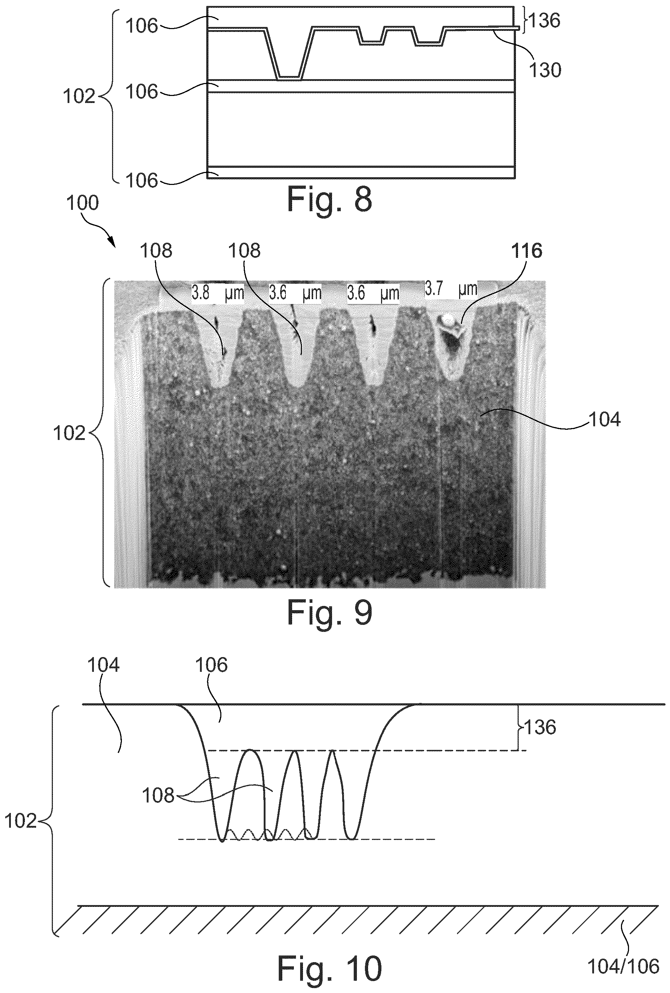

As described, the traces may be smaller than 4 µm in width which may be defined as a "small trace" or "small trench". Alternatively, said range may be from 4 µm to 20 µm which may be defined as a "broad trench" or "broad trace". Thus, traces configured as broad trench may be possible as well. In particular, bigger embedded traces may be used where the design of the electrically conductive layer structures, for example copper traces, can be more relaxed (for example at the periphery of the component carrier) or where the traces shall transmit bigger currents or dissipate more thermal energy. For instance, a plurality of laser shots may be used in order to create such broad traces. In a cross-sectional view, this may be seen as a wavy bottom portion of the trace at the bottom dotted line of Figure 10, wherein said wavy bottom portion may have a significantly lower oscillation amplitude than the traces 108 shown there. In an example, a small trace can be in close proximity to the broad trace. When having broad traces, the line space ratio L/S of a trace can be bigger than mentioned before, for example more than 10 µm/10 µm, for instance 20 µm/20 µm or more.

In an embodiment, in the cross section, the at least one trace has a trace area in a range from 1 µm² and 25 µm², in particular in a range from 6 µm² and 18 µm². Hence, tiny traces with precisely defined geometrical properties may be produced which cover only a very small area. Due to the specific shape imparted in the recess formation, in particular by a laser beam, the formed trace with the above mentioned ranges for a "small trace" results with a suitable cross section area as above disclosed.

In an embodiment, the lateral walls of the at least one trace are inclined, beginning from the exterior surface, with respect to a stack thickness direction by an inclination angle in a range from 1° and 30°, in particular in a range from 5° to 15°. In any case, immediately beginning from the exterior surface, the lateral walls may extend in a non-vertical way. This may bring the advantage of ensuring reliable signal transmission and mechanical integration of the trace into the stack, through the shape resulting from the trench formation, in particular through a laser beam.

In an embodiment, a roughness Ra of the lateral walls of the at least one trace is different from (for example larger than) a roughness Ra of the exterior surface of the at least one trace. In the context of the present application, the term "roughness" may particularly denote the centerline average height Ra of a surface. Ra is the arithmetic mean value of all distances of the profile from the centerline. For instance, the measurement or determination of roughness Ra, as mentioned in the context of the present application, may be carried out according to DIN EN ISO 4287:2010 (which is an industrial standard). These different roughness values may be the result of a manufacturing process during which the lateral walls are defined by laser processing, whereas the exterior surface may be defined by a planarizing process such as chemical mechanical polishing (CMP). More generally, the exterior surface may be defined by any removal process, such as etching or grinding, in particular CMP.

In an embodiment, a roughness Ra of the exterior surface of the at least one trace is different from a roughness Ra of a main surface of the at least one electrically insulating layer structure (in particular the main surface where the trace is exposed). These different roughness values may be the result of different materials of the trace on the one hand and an embedding electrically insulating layer structure on the other hand. While the latter may comprise reinforcing particles such as glass beads which may be exposed to increase the surface roughness, the former may be metallic (in particular copper) material which may have a smoother surface.

In an embodiment, the component carrier comprises a plurality of traces arranged side-by-side in the at least one electrically insulating layer structure. Advantageously, a plurality of traces may be formed in a common simultaneous process. For instance, several trenches may be formed in the same electrically insulating layer structure side-by-side by laser processing. Subsequently, said traces may be filled with a metal by a common plating process. Thereafter, a common removal process, for example a planarizing process (such as CMP) may be carried out for removing excessive metallic material to thereby separate the individual traces from each other.

In an embodiment, different ones of the traces have different maximum horizontal width, and/or different inclination angle of the lateral walls at the exterior surface, and/or different vertical thickness one to each other. In particular, adjacent traces may have one or more of these differences one to each other. Such differences may be created by adjusting the laser processing properties for the different traces separately and/or by different local interaction of the laser with the material to removed, for example due to the different distribution of the fillers in said material, especially when the trenches are formed by one shot laser passage. Thus, even when the respective traces have different maximum horizontal width, different inclination angle of the lateral walls at the exterior surface, and/or different vertical thickness, the traces may have reliable mechanical integration and/or electronic signal transmission. Furthermore, the respective traces may be easily formed by the same manufacturing process, which may shorten the entire manufacturing time of the component carrier.

In an embodiment, the at least one trace is configured as signal trace, power trace, or ground trace. A signal trace may be a trace which is configured and connected for conducting an electric (for instance also high-frequency) signal or an optical signal during operation of the component carrier. A power trace may be a trace which is configured and connected for supplying electric power to at least one consumer of a component carrier during operation. A ground trace may be a trace which is connected to an electric ground potential or mass potential, or more generally to an electric reference potential. This may bring the advantage that a plurality of traces may be manufactured using the same manufacturing method, wherein the respective traces may have different application purpose, which may simplify the manufacturing process.

In an embodiment, a minimum distance of the at least one rounded edge of the at least one trace from a main surface of an electrically insulating layer structure opposing the exterior surface is at least 0.8 times (preferably a value in a range from 0.8 to 1.5) a maximum horizontal width of the at least one trace and/or is at least 0.8 times a vertical thickness of the at least one trace. Other dimensions are possible as well. This may bring the advantage of ensuring reliable electrical signal transmission in combination with variable dimension of extension of the respective traces.

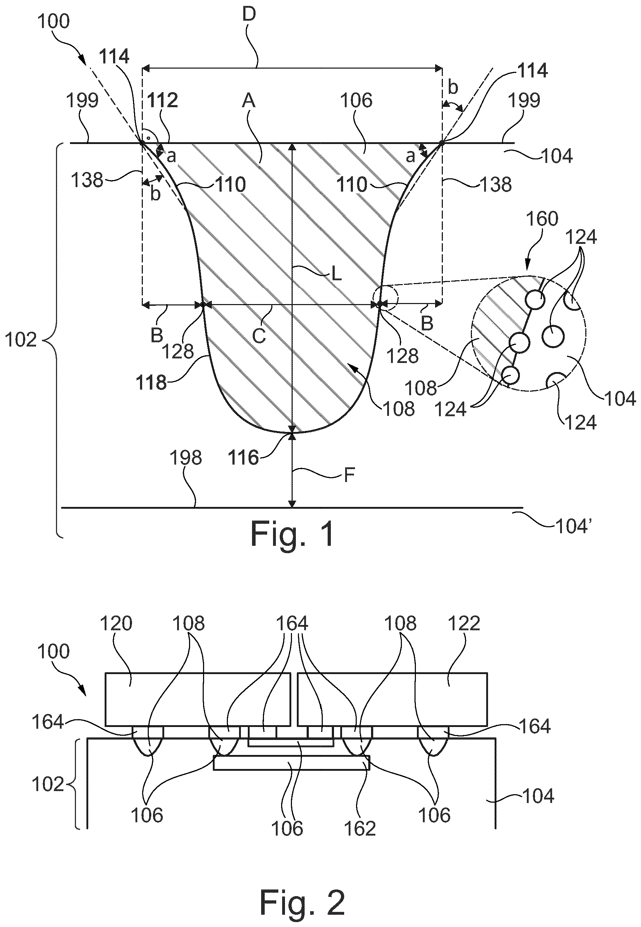

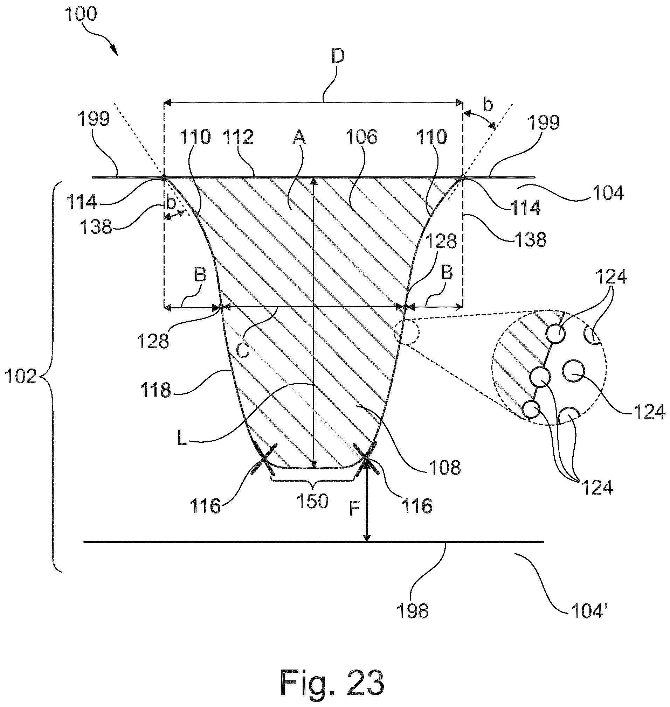

For example, the minimum distance of the at least one rounded edge (of Figure 1) or the flat portion (of Figure 23) of the at least one trace from a main surface of an electrically insulating layer structure opposing the exterior surface may be at least 1 µm. Preferably, said minimum distance may be in a range from 1 µm to 5 µm. This may ensure that no short circuits by an arcing phenomenon are happening.

In an embodiment, two embedded traces are misaligned one to each other in a plan view. Such a misalignment may be a misalignment concerning corresponding geometrical dimensions of different traces, a misalignment according to an arrangement direction of multiple traces and/or perpendicular thereto, etc. The corresponding manufacturing method may create traces, which may be misaligned with each other by a distance smaller than 2 µm, in particular smaller than 800 nm. Nevertheless, said misalignment may have a small impact on the signal transmission behavior of the trace and thus may ensure a reliable component carrier in term of signal quality.

In an embodiment, two adjacent embedded traces are arranged at a center-to-center distance from each other, wherein the center-to-center distance is smaller than 15 µm, in particular smaller than 5 µm. Hence, a very high integration density may be obtained by applying manufacturing concepts according to exemplary embodiments. For example, of the component carrier may comprise a center-to-center distance between two adjacent embedded traces in a range from 2 µm to 10 µm, preferred in a range from 3 µm to 6 µm. Additionally or alternatively, the component carrier may comprise a center-to-center distance between two adjacent embedded traces in a range from 15 µm to 45 µm (in particular in case of broad embedded traces).

In an embodiment, the component carrier comprises two components arranged in and/or on said stack, wherein at least one trace is configured to connect said two components. In the context of the present application, the term "component" may particularly denote a device or member, for instance fulfilling an electronic task. For instance, the component may be an electronic component. Such an electronic component may be an active component such as a semiconductor chip comprising a semiconductor material, in particular as a primary or basic material. The semiconductor material may for instance be a type IV semiconductor such as silicon or germanium, or may be a type III-V semiconductor material such as gallium arsenide. In particular, the semiconductor component may be a semiconductor chip such as a naked die or a molded die. At least one integrated circuit element may be monolithically integrated in such a semiconductor chip. However, the component can also be a passive component. Advantageously, one or more traces manufactured as described herein can be used for connecting two of such surface mounted electronic components being arranged side-by-side. Thus, the traces may accomplish or may contribute to an electric connection of two such surface mounted electronic components in a simple and compact way.

In an embodiment, the at least one electrically insulating layer structure in which the at least one trace is embedded is free of reinforcing fibers. For instance, the at least one electrically insulating layer structure in which the at least one trace is embedded comprises reinforcing beads or is free of reinforcing particles. When forming a trench or recess in an electrically insulating layer structure comprising, for instance, glass fibers by laser processing, laser cut ends of reinforcing fibers may extend into the recess or trench and may significantly increase roughness at an interface. This may be disturbing for instance for high frequency applications after filling the recess or trench with metal. In order to keep the roughness in reasonable limits, it may be possible to embody the electrically insulating layer structure without reinforcing fibers. In one embodiment, reinforcing beads or spheres may be used rather than reinforcing fibers. This may allow to provide an electrically insulating layer structure with good mechanical stability while at the same time avoiding excessive roughness due to laser cut reinforcing fibers extending into the laser cut recesses or trenches. In still another embodiment, no reinforcing particles may be included at all in said electrically insulating layer structure. For example, the electrically insulating layer structure may comprise a resin, for instance epoxy resin, and optionally reinforcing particles such as beads, which may be made, for instance, of glass.

In an embodiment, the stack comprises a plurality of electrically insulating layer structures, wherein different traces are embedded in different ones of the plurality of electrically insulating layer structures. Hence, the process of stacking layer structures and forming metallic traces therein by laser processing, plating and planarizing may be repeated any desired number of times until a predefined build up to be manufactured is completed. This may reduce the overall thickness of the stack, since different traces are embedded in respective different electrically insulating layer structures.

In an embodiment, said different ones of the plurality of electrically insulating layer structures are stacked on top of each other. Thus, the trace manufacturing architecture according to exemplary embodiments is compatible with any layer count.

In an embodiment, different traces embedded in different ones of the plurality of electrically insulating layer structures are electrically coupled with each other. In particular, stacked electrically insulating layer structures with embedded stacked traces having the above mentioned characteristics may be formed which may be directly or indirectly (for instance by metallic pads, metallic pillars, etc. in between) electrically coupled with each other. This may enhance a local density of electrically conductive layer structure material and thus may enable to create complex designs of an electrically conductive layer structure being vertically interconnected when the plurality of electrically insulating layer structures are stacked on top of each other.

In an embodiment, the at least one trace has a turning point arranged between said slanted lateral walls and said at least one rounded edge, wherein a curvature of an interface between said at least one trace and the at least one electrically insulating layer structure changes from right curved to left curved, in particular at the turning point. In another embodiment, the at least one trace has a turning point arranged between said slanted lateral walls and said sharp edges, wherein a curvature (in particular along the thickness direction) of an interface between said at least one trace and the at least one electrically insulating layer structure changes from the turning point to the sharped edge. Advantageously, a continuous smooth transition between a concave curved and a convex curved section of the trace may be achieved, through the specific recess formation step, in particular through a laser beam. Additionally or alternatively, due to this special shape of the at least one trace an electronic signal may be transmitted with reduced losses, since the electronic signal is guided through the convex and/or concave sections.

In an embodiment, a ratio between a horizontal distance from one of said sharp edges to said turning point and a horizontal distance of the turning point at the opposing lateral walls is in a range from 0.1 to 0.7, in particular in a range from 0.1 to 0.3. Such a design may be achieved by forming the traces based on laser created trenches being overplated followed by a subsequent planarization, in particular CMP planarization. Additionally or alternatively, such a specific shape of the trace may ensure that the trace is capable of transmitting power and/or a signal.

In an embodiment, the at least one rounded edge is one common rounded edge for the two lateral walls. Such a configuration is shown in Figure 1. In another embodiment, the at least one rounded edge comprises two rounded edges, for example connected with each other by a flat portion in between. Such a configuration is shown in Figure 23. Depending on the processing parameters, in particular during laser processing for creating trenches forming the basis for the traces obtained after metal filling, the one or the other configuration may be obtained. In an example, for specific applications, a trace having a shape comprising one common rounded edge for the two lateral walls, for example for electronic signal transmission may be preferred. In another example, for specific applications, a trace having a shape comprising two common rounded edges for the two lateral walls, for example for electronic power transmission may be preferred.

In an embodiment, the method comprises forming a first portion of the at least one trace by seed layer deposition For instance, such a seed layer may be formed by electroless plating or sputtering of metallic material such as copper. Seed layer deposition may generally denote a preparation of a seed layer using chemical processes (so called electroless process) and/or physical processes (for example physical vapor deposition , in particular sputtering). The presence of a seed layer lining a trench in an electrically insulating layer structure may simplify a subsequent thickening of the metal filling by electroplating.

In an embodiment, the method comprises forming a second portion of the at least one trace by galvanic plating on the first portion. For galvanic plating or electroplating, a pre-formed seed layer lining the interior surface of the trench in the electrically insulating layer structure may be advantageous. The electroplating process may be executed in one or a plurality of subsequent electroplating stages until the trenches are completely filled with metallic material and excessive metallic material connects neighboring traces as overlapping region. When subsequently removing excessive material in the overlapping region, preferably including planarizing the metallic structures, the individual traces may be separated and the above-described characteristic geometric trace design with excellent adhesion properties with respect to embedding dielectric material may be obtained.

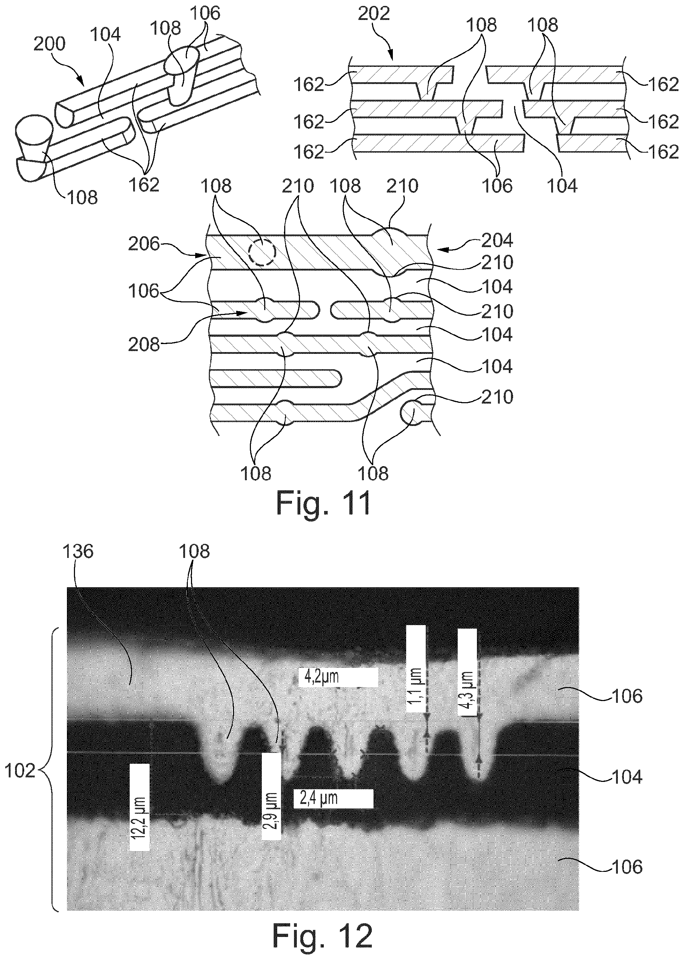

In an embodiment, the method comprises forming at least two recesses in the at least one electrically insulating layer structure, filling the at least two recesses and an overlapping region between said at least two recesses with electrically conductive material, and thereafter removing an excessive part of said electrically conductive material of the overlapping region to thereby separate remaining electrically conductive material to obtain separate at least two traces. In particular, the resulting overlapping region may extend vertically beyond the respective main surface of the at least one electrically insulating layer structure. For instance, there may be a dimple or shallow recess in the overlapping region due to the fact that more copper is plated in the traces, as can be seen from Figure 12. Preferably, the removal of the excessive part of said electrically conductive material of the overlapping region comprises a partial removal of the material of the at least one electrically insulating layer structure, more preferably decreasing the thickness of the at least one electrically insulating layer structure. As a result of this process, a planarized surface may be obtained which is formed partially by the electrically insulating layer structure and partially by the embedded traces.

In an embodiment, the method comprises forming at least one recess in the at least one electrically insulating layer structure by a laser beam, and (preferably thereafter) filling the at least one recess with electrically conductive material for forming said at least one trace. For instance, a single laser shot may be sufficient for forming the recess or trench. In other embodiments, a plurality of laser shots may be executed. The laser processing may involve a UV (ultraviolet) laser or a laser operating in the visible range. The laser source may emit a continuous laser beam or may be a pulsed laser source. A pulsed laser may be a picosecond laser, a femtosecond laser or a nanosecond laser. Preferably, the method comprises forming the pulsed laser beam with laser light pulses having a temporal length and/or a temporal distance of not more than 1 ps.

In an embodiment, the method comprises forming the at least one recess by only one laser shot (or by a plurality of laser shots) moving along a main surface of the at least one electrically insulating layer structure in accordance with a trajectory of the at least one trace to be formed. In one embodiment, the electrically insulating layer structure or panel may remain spatially fixed while the laser source scans over its surface. In another embodiment, the electrically insulating layer structure or panel may move for scanning while the laser source remains spatially fixed. This may bring the advantage of simplifying the manufacturing process of the embedded traces and/or embedded trenches and thus may accelerate the manufacturing process of the component carrier.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a trace of a component carrier according to an exemplary embodiment of the invention.
Figure 2 illustrates a cross-sectional view of a component carrier according to another exemplary embodiment of the invention.
Figure 3 illustrates a cross-sectional view of a component carrier according to still another exemplary embodiment of the invention.
Figure 4 to Figure 8 illustrate cross-sectional views of structures obtained during carrying out a method of manufacturing a component carrier, shown in Figure 3, according to an exemplary embodiment of the invention.
Figure 9 illustrates a cross-sectional image of traces of a component carrier according to an exemplary embodiment of the invention.
Figure 10 illustrates a cross-sectional view of a preform of traces of a component carrier according to an exemplary embodiment of the invention.
Figure 11 illustrates a three-dimensional view, a cross-sectional view and a plan view of traces and trenches of a component carrier according to an exemplary embodiment of the invention.
Figure 12 and Figure 13 illustrate cross-sectional images of preforms of traces of a component carrier according to an exemplary embodiment of the invention.
Figure 14 illustrates a cross-sectional view of a trace of a component carrier according to an exemplary embodiment of the invention.
Figure 15 to Figure 19 illustrate cross-sectional views of traces of component carriers according to an exemplary embodiment of the invention.
Figure 20 and Figure 21 illustrate cross-sectional image of traces or preforms of traces of component carriers according to exemplary embodiments of the invention.
Figure 22 illustrates a cross-sectional view of a preform of two traces of a component carrier according to an exemplary embodiment of the invention.
Figure 23 illustrates a cross-sectional view of a trace of a component carrier according to another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

Conventionally, conductive lines and traces are manufactured in PCB technology by a subtractive process involving etching or by an additive process. Both manufacturing concepts work in such a way that the traces are created on top of a dielectric layer that has been applied before.

However, a conventional additive process requires etching of a seed layer after plating, which may involve the following challenges: On the one hand, etching is an isotropic process, so that all features will be etched from all sides equally, removing not only the seed layer on the bottom, but also removing copper material from the sidewalls. Thus, an etch factor needs to be considered which is cumbersome. Another conventional shortcoming is that the etching process may form an undercut in many cases, thereby creating a small indentation at the foot of traces where the seed layer meets the dielectric beneath. This indentation may influence the adhesion and mechanical reliability in an undesired way.

According to an exemplary embodiment, a component carrier (like an IC substrate or a PCB) is provided with a stack of interconnected layer structures including metallic traces embedded in (rather than formed on) an electrically insulating layer structure, such as a resin sheet comprising optionally reinforcing particles, of the stack. In a cross-sectional view, two opposing lateral walls of the trace may be inclined or slanted inwardly already at an exterior trace surface where it extends out of its embedding electrically insulating layer structure. At the same exterior surface, two sharp edges of the trace - each of which being assigned to a respective one of said opposing lateral sidewalls- may be arranged on an opposing vertical side with respect to a rounded edge (or with respect to two rounded edges) at or close to an interior end or extremity of the trace. These structural attributes of a trace may be obtained by forming a recess in the electrically insulating layer structure by a single laser shot of a moving laser beam scanning along a main surface of the at least one electrically insulating layer structure in accordance with a trajectory of the extension of the trace being presently formed. After said laser-based trace trajectory definition, the recess may be filled partially or entirely by an electrically conductive material, for example metal (preferably copper), which may be applied for example by electroless plating followed by electroplating. Advantageously, the trace manufacturing process may fill a plurality of juxtaposed trace recesses with an electrically conductive material, for example metal, wherein adjacent preforms of traces may be interconnected by excessive electrically conductive material in an overlapping region. Thereafter, said spaces may be separated by removing excessive electrically conductive, in particular metallic, material extending perpendicularly, in particular vertically, beyond the traces to be formed, thereby leaving behind traces with the above described shape. Advantageously, traces formed by such a manufacturing process and having the above-mentioned geometrical properties may be highly appropriate for fine line structuring applications in which a high integration density of traces and a small line space ratio is desired. Hence, compact component carriers with sophisticated electronic functionality may be provided according to exemplary embodiments.

Said embedded trace formation may allow to overcome at least part of the above-mentioned and/or other conventional shortcomings. In particular, embedded trace formation may contribute to a desired miniaturization of component carrier features, may allow an increased functionality of the component carrier, may be compatible with a higher integration density, and may in particular be compatible with the formation of smaller features. Beneficially, the line space ratio (L/S) of a component carrier (such as a PCB or an IC substrate may be advantageously decreased. In particular, embedded trench technology for forming embedded traces in a substrate or the like may allow the formation of fine line structures with a line space ratio L/S below 3 µm. More specifically, this may be achieved by forming an intended overlap between different preforms of traces before removing at least part of said overlapping metallic material.

In particular, exemplary embodiments of the invention may provide a manufacturing architecture of forming (preferably electrically) conductive traces or lines of a component carrier (such as a PCB or an IC substrate) by lasering trenches or recesses into a dielectric material (for instance using an excimer laser), followed by plating electrically conductive, in particular metallic, trace material in the trenches or recesses, and surface planarization. As a result, the (in particular electrically and/or thermally) conductive traces may be embedded into the dielectric material of an electrically insulating layer structure, instead of creating metallic traces on top of it. During the structural formation of traces having desired line and space attributes, an intentional overlap between preforms of adjacent traces may be formed. By removing an overlapping portion of an electrically conductive (for instance galvanic) plating structure for separating different traces from each other, highly reliable and miniature traces may be created with very small structural dimensions. By forming (in particular electrically and/or thermally) conductive traces embedded into a dielectric layer material using an intended overlap, it may be possible to improve the adhesion of the electrically conductive material (in particular copper) on the embedding electrically insulating layer structure (in particular a resin, optionally comprising reinforcing particles). Descriptively speaking, a better adhesion of copper traces to the dielectric material may be achieved since - in a cross-sectional view - three sides of the metallic traces may stick to the electrically insulating material, instead of only one side in conventional approaches. Moreover, no seed layer etching may be required according to exemplary embodiments, meaning that no disturbing undercut of traces may be created. Therefore, smaller L/S values may be possible (preferably below 3 µm). Apart from this, less processing stages may be sufficient for manufacturing said traces, in particular compared with additive lithography. This may reduce the manufacturing effort. Furthermore, an improved flatness of the stack may be achieved due to the execution of a planarizing excessive metal removal process, such as chemical mechanical polishing (CMP). This may lead to advantageous properties in terms of surface topography.

Apart from advantageous properties concerning miniaturization of the manufactured component carriers, fan-out panel level packaging (FO-PLP) devices may be manufactured with a manufacturing architecture according to exemplary embodiments. Moreover, ultra-high density fan-out devices may be possible, as well as high performance computing (HPC) devices.

The manufactured traces may have a characteristic feature shape due to the underlying laser process of forming corresponding recesses of trenches. In particular, a characteristic taper may be obtained due to a substantially Gaussian beam shape. Also formation of an intended metal overlap followed by a surface planarizing material removal process may have an impact on the final shape of the traces.

According to an exemplary embodiment of the invention, a component carrier is provided which comprises a stack comprising at least one electrically insulating layer structure and at least one electrically conductive layer structure, said at least one electrically conductive layer structure comprising at least one trace embedded in the at least one electrically insulating layer structure, said at least one trace comprising a cross section composed of two lateral walls slanted away from the surface where said embedded trace is exposed and configured to define two sharped edges at the exposed side and one rounded edge at the opposed extremity.

In particular, a maximum horizontal width divided by a vertical thickness of the trace may be between 0.05 and 3 (which may correspond to small traces). For instance, the rounded edge smoothly merges toward the two slanted lateral walls. For example, the rounded edge defines a tangent transition with the respective slanted lateral wall. In an embodiment, no edge is resulting from the transition between the rounded edge and the slanted lateral walls. For instance, the slanted lateral wall has a (for example substantially) straight direction. Alternatively, the slanted lateral wall may have a curved shape. In an embodiment, the slanted lateral wall has an irregular shape following a straight direction (which may be slanted with respect to the stack direction). Alternatively, the slanted lateral wall may have an irregular shape following a curved direction. For instance, the maximum horizontal width of the trace is between 0.5 µm and 4 µm, in particular between 1 µm and 3.5 µm. Alternatively, said range may be from 4 µm to 20 µm (which may correspond to broad traces). In an embodiment, the cross sectional area of the trace is between 1 µm² and 25 µm², in particular between 4 µm² and 22 µm². For example, the lateral wall of the trace is inclined with respect to the stack thickness direction of a value between 1° to 30°, in particular between 3° and 20°. For instance, a roughness Ra of the lateral walls is different from the roughness Ra of the surface where the trace is exposed or extends horizontally. For example, the roughness Ra of the surface where the trace is exposed or extends horizontally is different from the roughness Ra of the main surface of the at least one electrically insulating layer structure. In particular, a trace may be formed by seed layer deposition. In an embodiment, several traces may be formed one beside the other. They may have different widths, lateral walls inclination, trace thickness (for example, one trace may be composed of a via (wherein length and width may be roughly equal although the thickness may be significantly different). For instance, the traces may be embodied as signal traces. In particular, the minimum distance of the rounded portion of the trace and the main surface of the electrically insulating layer opposed from the surface exposing the trace may be at least 0.8 times the maximum width or thickness of the trace. For example, the two embedded traces are misaligned one to each other in a planar direction. Additionally or alternatively, the two embedded traces may be aligned one to each other in planar direction. In an embodiment, the two embedded traces are distanced from each other, wherein the distance is smaller than 10 µm, in particular smaller than 1.5 µm (when considering a center-to-center distance). However, a distance between broad traces can be larger. For example, at least one trace may be configured to connect two components provided in and/or on said component carrier. For instance, the electrically insulating layer in which the trace is embedded is free of reinforcing fibers. For example, several layer structures composing the stack may be foreseen, wherein at least two embedded traces may be provided for a respective insulating layer structure. In an embodiment, the component carrier further comprises a further electrically insulating layer structure having at least one further electrically conductive trace embedded in or located on the layer with traces. In embodiments, trace and further trace of a further layer are connected with each other.

According to an exemplary embodiment, conductive traces of a component carrier may be embedded into a dielectric layer material of a PCB or IC substrate, instead of creating traces on top of dielectric material. This may improve the adhesion of the metallic material (in particular copper) of the traces to the dielectric material. This may also enable to manufacture fine lines with a line space ratio L/S of, for example, less than 3 µm. However, broad traces can have a line space ratio L/S larger than 20 µm.

For obtaining the above-mentioned, below-mentioned and/or other advantages, it may be possible to manufacture the traces in accordance with the following manufacturing process: Firstly, a dielectric layer (for example a resin sheet, for instance pure or comprising reinforcing particles such as glass spheres or glass fibers, or a photoimageable dielectric) may be laminated on a stack. Thereafter, trenches may be formed in the dielectric material with intended overlap between adjacent trenches. For instance, this may be accomplished by formation of the trenches by an excimer laser in a resin sheet and cleaning, or by an exposure and developing for a photoimageable dielectric. In an optional subsequent process, an adhesion promoter may be applied. Thereafter, a metal seed layer plating process can be executed, for instance electroless plating of copper or another metal. In a subsequent processing stage, a metallic pattern may be overplated, for instance by electroplating of copper or another metal. Thereafter, excessive metallic material may be removed, for instance by executing chemical mechanical polishing (CMP). Advantageously, no seed layer etching needs to be carried out during such a manufacturing process, in contrast to conventional additive trace formation processes. This may lead to a reduced manufacturing effort of exemplary embodiments.

Exemplary embodiments of the invention may have advantages: In particular, an excellent adhesion of the traces (for instance made of copper material) to the dielectric material of the embedding electrically insulating layer structure may be achieved, since a sticking or adhering effect may be achieved at plural sides compared with only one side in conventional approaches. Beneficially, no seed layer etching needs to be carried out according to exemplary embodiments so that no undercut of traces occurs. Therefore also the creation of very small line space ratios L/S of for example less than 3 µm may be made possible according to exemplary embodiments. In comparison with additive lithography, the manufacturing process according to exemplary embodiments may involve a lower number of processing stages, which may further reduce the manufacturing effort. Apart from this, an improved flatness of the stack may be achieved due to the execution of a planarizing process such as CMP for adjusting a surface topography.

**Figure 1** illustrates a cross-sectional view of a trace 108 of a component carrier 100 according to an exemplary embodiment of the invention. For example, the component carrier 100 (only a small part thereof is shown in Figure 1) may be a printed circuit board (PCB) or an integrated circuit (IC) substrate. For example, the illustrated trace 108 may be configured as signal trace, power trace, or ground trace in the framework of the functionality of the component carrier 100.

The illustrated component carrier 100 comprises a laminated layer stack 102 comprising one or more electrically insulating layer structures 104 (including 104') and one or more electrically conductive layer structures 106. Said layers 104, 106 may be interconnected by lamination, i.e. the application of elevated temperature and/or pressure. The electrically insulating layer structures 104 may comprise resin, in particular epoxy resin, and optionally reinforcing particles, such as glass spheres. More generally, the electrically insulating layer structures 104 may comprise a sheet of prepreg, resin, photoimageable dielectric, a solder resist or glue, and/or a glass plate or a glass core. The electrically conductive layer structures 104 may be configured as copper filled laser vias, patterned metal layers such as copper foils and/or deposited copper material. The electrically conductive layer structures 106 may fulfill different functions, such as the vertical transmission of signals and/or electric energy by vertical through connections such as copper pillars or stacked copper filled laser vias. Moreover, the electrically conductive layer structures 106 may comprise horizontal lines or traces 108 transmitting electric signals and/or electric power within a horizontal plane.

In the following description referring to Figure 1, the focus will be on electrically conductive layer structures 106 configured as horizontal traces 108, made preferably of copper, and being embedded in an electrically insulating layer structure 104 which may be preferably a resin sheet for instance formed on the basis of an epoxy resin. Of course, other materials are possible.

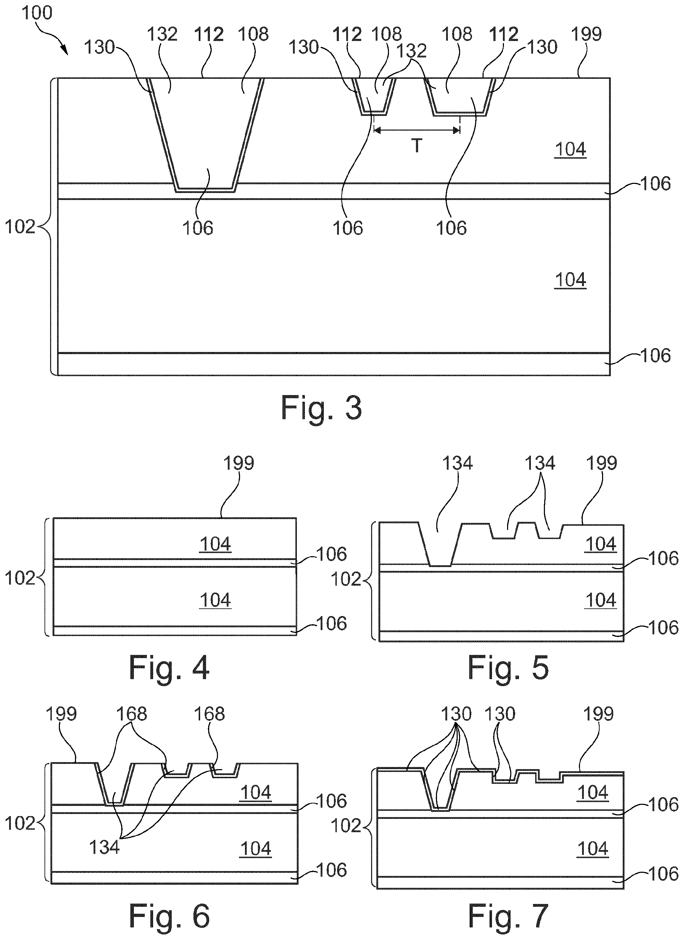

The electrically conductive layer structure 106 shown in Figure 1 is embodied as a horizontal metallic trace 108 embedded in a resin-based horizontal layer in form of the embedding electrically insulating layer structure 104. The horizontal trace 108 extends in an elongate fashion as an oblong wiring structure perpendicular to the paper plane of Figure 1 (not shown). Due to a trace manufacturing process, which will be described below in further detail referring to Figure 3 to Figure 8, the copper trace 108 shown in the cross-sectional view of Figure 1 has a characteristic appearance which will be described in the following. As shown in Figure 1, said trace 108 comprises in the illustrated cross section two laterally opposing lateral walls 110 constituting sidewalls of the trace 108. As illustrated, said lateral walls 110 are slanted inwardly beginning from an exterior surface 112 of the trace 108, said exterior surface 112 being aligned with a main surface 199 of the electrically insulating layer structure 104 in which said trace 108 is embedded. Thus, already at the upper exterior main surface 199 of the electrically insulating layer structure 104 which is located at the same vertical level as the upper exterior surface 112 of the trace 108, the copper trace 108 begins to be slanted for tapering towards an interior of the electrically insulating layer structure 104 rather than extending purely vertically. As shown, said embedded trace 108 is exposed with respect to the embedding electrically insulating layer structure 104 at the exterior surface 112. This geometrical characteristic of the copper trace 108 is the fingerprint of its manufacturing process. More specifically, the mentioned shape is a fingerprint of a laser process executed for forming a trench, which is thereafter filled by a metal with overlap to at least one other trench, before excessive metal is removed for separating the metal-filled trenches forming individual traces 108 as the one shown in Figure 1.

Referring again to Figure 1, the illustrated cross-section of the trace 108 shows two sharp edges 114 at an interface between the exterior surface 112 and the slanted lateral walls 110 and shows one common rounded edge 116 at an opposed extremity or end with respect to the exterior surface 112. More specifically, each of said sharp edges 114 is formed at a respective interface between the exterior surface 112, on the one hand, and a respective lateral wall 110 on the other hand. An acute trace-internal angle α is formed at a discontinuity between the exterior surface 112 and a respective lateral wall 110, as indicated in Figure 1. The acute trace-internal angle α may be different on the left-hand side and on the right-hand side of Figure 1 (for instance due to a limited precision of a laser process). Rather than forming a sharp angle, the common rounded edge 116 at a bottom end of the metallic trace 108 forms a curved continuous structure and constitutes the lower extremity of the (at least substantially) axially symmetrical cross-section of trace 108 according to Figure 1. As shown in Figure 1, the single common rounded edge 116 continuously merges into the two slanted lateral walls 110.

Again referring to Figure 1, trace 108 has a turning point 128 arranged between said slanted lateral walls 110 and said common rounded edge 116. A curvature of a boundary wall or an interface 118 between said metallic trace 108 and the electrically insulating layer structure 104 changes between right curved and left curved at the turning point 128.

Preferably, a ratio between a maximum horizontal width D of trace 108 at the exterior surface 112 and a vertical thickness L of the metallic trace 108 from the exterior surface 112 up to the common rounded edge 116 may be in a range from 0.1 to 0.5. For instance, the maximum horizontal width D of the copper trace 108 may be in a range from 1.5 µm to 2.5 µm. In the illustrated cross section, the copper trace 108 has a trace area A which may be preferably in a range from 6 µm² and 18 µm². While a section of the slanted lateral walls 110 extends substantially straight according to Figure 1, other sections of the slanted lateral walls 110 may be curved in a concave fashion or in a convex fashion, respectively. As shown, the lateral walls 110 of the copper trace 108 are inclined, beginning from the exterior surface 112, with respect to a vertical stack thickness direction 138 by an inclination angle β preferably in a range from 5° to 15°. The inclination angle β may be different on the left-hand side and on the right-hand side of Figure 1 (for instance due to a limited precision of a laser process). In other words, the angle β between the vertical stack thickness direction 138 and a tangent on the exterior surface of the trace 108 may be in said angular range. Both the acute trace-internal angle α and the inclination angle β may have the same angular point in form of sharp edge 114. As shown as well in Figure 1, a minimum vertical distance F from the rounded edge 116 of the trace 108 to a main surface 198 of an adjacent electrically insulating layer structure 104' opposing the exterior surface 112 may be at least 0.8 times of the maximum horizontal width D of the trace 108 and/or may be at least 0.8 times of the vertical thickness L of the trace 108. Alternatively, the minimum vertical distance F from the rounded edge 116 of the trace 108 to a main surface 198 of an adjacent electrically insulating layer structure 104' opposing the exterior surface 112 may be at least 0.6 times of the maximum horizontal width D of the trace 108 and/or may be at least 0.6 times of the vertical thickness L of the trace 108. A ratio between a horizontal distance B from a respective sharp edge 114 to said turning point 128 and a horizontal distance C between the turning points 128 at the opposing lateral walls 110 may be preferably in a range from 0.1 to 0.3. Alternatively, the ratio between a horizontal distance B from a respective sharp edge 114 to said turning point 128 and a horizontal distance C between the turning points 128 at the opposing lateral walls 110 may be preferably smaller than 0.45.

Moreover, a roughness Ra of the lateral walls 110 of the trace 108 may be different from, in particular larger than, a roughness Ra of the exterior surface 112 of the trace 108. This may be the result of the manufacturing process, during which the lateral walls 110 of the trace 108 may be defined by a laser process (in particular by excimer laser processing), whereas the planar exterior surface 112 may be defined by a planarization process (in particular CMP). Moreover, the roughness Ra of the exterior surface 112 of the trace 108 may be different from (for example smaller than) a roughness Ra of a connected portion of main surface 199 of the embedding electrically insulating layer structure 104, wherein the exterior surface 112 and said main surface 199 may be at the same vertical level and in alignment with each other.

Preferably, the electrically insulating layer structure 104 in which the trace 108 is embedded may be free of reinforcing glass fibers. For instance, the trace 108 may comprise reinforcing glass spheres or reinforcing beads 124, as indicated in a detail 160 of Figure 1. The absence of glass fibers may ensure that the trace 108 can be provided with relatively smooth walls. This may be advantageous in particular for high frequency applications when high-frequency signals propagate along trace 108. When having relatively smooth walls, trace 108 contributes to low signal distortion by suppressing signal losses in view of the so-called skin effect according to which an electric current flows only or at least predominantly along a thin skin at an exterior surface of the trace 108 at high frequencies. For this reason, detail 160 indicates that the electrically insulating layer structure 104 in which the trace 108 is embedded comprises for example spherical reinforcing beads 124. Alternatively, said electrically insulating layer structure 104 may be entirely free of reinforcing particles, for instance may be a pure resin sheet, optionally with additives. Optionally, the spherical reinforcing beads 124 may be in direct contact with the trace 108, in particular the lateral walls 110 of the trace 108. This may bring the advantage of better adhesion between the trace 108 and the electrically insulating layer structure 104.

Although not shown, the stack 102 may also comprise a plurality of vertically stacked electrically insulating layer structures 104, wherein different traces 108 are embedded in different ones of the plurality of electrically insulating layer structures 104. Different traces 108 embedded in different ones of the plurality of electrically insulating layer structures 104 may be electrically coupled with each other, for instance by metallic vertical through connections (such as copper pillars or copper vias) which are not shown in Figure 1.

**Figure 2** illustrates a cross-sectional view of a component carrier 100 according to another exemplary embodiment of the invention.

The component carrier 100 according to Figure 2 comprises a laminated layer stack 102 comprising electrically insulating layer structures 104 and electrically conductive layer structures 106. The electrically conductive layer structures 106 comprise an embedded trench 162 which may for instance be fully filled with metal, in particular comprising copper. Said trench 162 can be electrically coupled with terminals 164 of two surface mounted electronic components 120, 122. For example, the electronic components 120, 122 may be semiconductor dies. The metallic terminals 164 of said electronic components 120, 122 may be electrically coupled with the embedded trench 162 by an electrically conductive connection medium (not shown) in between, such as solder, a sinter material and/or electrically conductive glue. As shown, the electronic components 120, 122 may be electrically coupled or connected by their terminals 164 and trench 162. It may also be possible that the two components 120, 122 arranged on said stack 102 are electrically coupled with each other by one or more traces 108 which can be configured for example as in Figure 1 or Figure 23. This may lead to a compact design of the component carrier 100. A further connection of terminals 164 of components 120, 122 by an additional electrically conductive layer structure 106 in a surface portion of stack 102 is shown as well in Figure 2.

The terminals 164 may be connection terminals of the respective component 120, 122. Reference numeral 162 may denote an embedded trench. The components 120, 122 may be connected by one or more embedded trenches 162 at different vertical levels.

The respective component 120, 122 may be connected to other (in particular lower) conductive layer structures by the embedded trace 108 and the connection portion below (for example by a respective through hole, via, etc., not shown, or by the trace 108 itself, as the left trace 108 shown in Figure 3).

**Figure 3** illustrates a cross-sectional view of a component carrier 100 according to still another exemplary embodiment of the invention.

In the embodiment of Figure 3, the component carrier 100 has a laminated layer stack 102 composed of a plurality of stacked electrically insulating layer structures 104 with electrically conductive layer structures 106 embedded therein and/or arranged in between and/or therein. In the uppermost electrically insulating layer structure 104, a plurality of metallic traces 108 are embedded side-by-side. It should be mentioned that the cross-sectional shape of the metallic traces 108 is only shown schematically in Figure 3 (and correspondingly in Figure 4 to Figure 8) and may have an appearance as shown in Figure 1 or Figure 23 when obtained from a real practical manufacturing process.

As shown, all traces 108 of Figure 3 extend from the upper main surface 199 of the embedding uppermost electrically insulating layer structure 104 so that the exterior surface 112 of the traces 108 is in alignment with and is at the same vertical level as the upper main surface 199 of said electrically insulating layer structure 104. However, different ones of the traces 108 may have different maximum horizontal width D, different inclination angle β of the lateral walls 110 at the exterior surface 112, different vertical thicknesses L, etc. (compare Figure 1). For instance, such different geometrical properties of different traces 108 may be adjusted by adjusting different processing parameters during forming trenches as a basis for the traces 108 by laser processing. It may also be possible that different embedded traces 108 are misaligned one to each other in a plan view. Alternatively, they may be aligned. Still referring to Figure 3, two adjacent embedded traces 108 may be arranged at a center-to-center distance T from each other. For instance, said center-to-center distance T may be smaller than 5 µm.

As also indicated in Figure 3, each of the traces 108 may be composed of a first portion 130, lining trenches formed as a basis for the manufacture of the metallic traces 108, and of a second portion 132 on the first portion 130 and filling the major portion of the trenches with electrically conductive material, in particular metallic material, such as copper. For instance, after having formed the trenches, the first portion 130 may be applied as a seed layer by electroless plating followed by the formation of the second portion 132 on the first portion 130 by galvanic plating. The trace 108 may be in contact with an electrically conductive layer structure at its bottom side (left trench in Figure 3). Furthermore, the trace 108 may have an elongated shape (different from standard laser vias).

Figure 4 to Figure 8 illustrate cross-sectional views of structures obtained during carrying out a method of manufacturing the component carrier 100 shown in Figure 3 according to an exemplary embodiment of the invention.

Referring to **Figure 4**, the planar layer stack 102 is shown which is composed of an alternating sequence of electrically insulating layer structures 104 and electrically conductive layer structures 106. Stack 102 may be formed by laminating, i.e. the application of elevated temperature and/or elevated mechanical pressure.

More specifically, stack 102 may be formed for example as a substrate for instance based on a copper clad laminate (CCL) with full or structured copper layer on both sides of a dielectric core. A dielectric layer may be applied on one side of the CCL. For example, such a dielectric layer or uppermost electrically insulating layer structure 104 may be embodied as a resin sheet, a non-photo-imageable built up material that consists of organic material with inorganic fillers in nano-scale size, etc.

Referring to **Figure 5**, a plurality of trenches or recesses 134 may be formed in the uppermost electrically insulating layer structure 104 by a laser beam (not shown). More specifically, it may be possible to form trench-shaped recesses 134 each by only one laser shot provided by a laser source moving along the main surface 199 of the uppermost electrically insulating layer structure 104 in accordance with a trajectory of the respective trace 108 to be formed. As shown in Figure 5, the different trenches (extending into the paper plane of Figure 5, not shown) or recesses 134 may have different or the same cross-sectional areas, widths and depths. Such different parameters may be adjusted by adjusting differently the laser processing parameters for forming the respective recess 134.

More specifically, it may be possible to form into said dielectric layer trenches and vias by using a laser light source (which may have any appropriate wavelength, for example an excimer laser emitting laser light at a wavelength of 305 nm). This may be accomplished in any desired design combination, such as for example one laser step or two laser steps, using for example a direct laser or an excimer laser mask. Said laser processing may form the basis of an intended overlap for line and space structures, compare Figure 8.

Referring to **Figure 6**, the structure obtained according to Figure 5 may be subjected to a cleaning process, for instance for removing laser residues. Optionally, it may also be possible to form an adhesion promoting layer 168 in the recesses 134.

Thus, the laser processed substrate may then be cleaned, for example in a wet or dry cleaning process, to remove laser residues.

Referring to **Figure 7**, a first portion 130 of the metallic trace 108 may then be formed in the trenches or recesses 134 by seed layer deposition. Said first portion 130 may be a thin copper layer lining the exposed surface portions of the layer structures 104, 106 in the trenches or recesses 134 and on the main surface 199.

Hence, a copper seed layer may be applied as the first portion 130, for example by electroless plating or PVD (physical vapor deposition), in particular sputtering, or chemical vapor deposition.

Referring to **Figure 8**, a second portion 132 of the traces 108 may be formed by galvanic plating of further metallic material on the first portion 130. As a result, each of the trenches or recesses 134 may be filled entirely with electrically conductive bulk material, for instance made of copper, for forming said traces 108. However, each of said trenches or recesses 134 may be overfilled or excessively filled with metal. The result of this overfilling may be the formation of a metallic overlapping region 136 on and between adjacent ones of said trenches or recesses 134. The second portion 130 and the overlapping region 136 may be formed by electroplating or galvanic plating and may comprise a metal such as copper. As a result, the structure shown in Figure 8 may be obtained. For this purpose, the trench and via structure may be filled by copper overplating (for instance electrolytic copper). For instance, also in Figure 8, there may be a dimple or shallow recess in an overlapping region due to the fact that more copper is plated in the traces, as can be seen from Figure 12.

In order to obtain component carrier 100 according to Figure 3 based on the structure shown in Figure 8, it may be possible to remove an excessive part of said electrically conductive material of the overlapping region 136 to thereby separate remaining electrically conductive material to obtain the separate traces 108. For this purpose, a planarizing process, such as a CMP (chemical mechanical polishing) process, may be applied to remove excessive copper from the surface on top and also the extra dielectric material. By the planarizing process, metal of structures 130, 132, 136 and dielectric material of electrically insulating layer structure 104 may be removed.

As a result, the electrically conductive layer structures 106 are formed with the metallic traces 108 which are embedded in a surface portion of the outermost electrically insulating layer structure 104, as shown in Figure 3. Now referring additionally to Figure 1 or Figure 23, each of said traces 108 may be formed so that it comprises, in a cross section, two lateral walls 110 slanted inwardly beginning from an exterior surface 112 and so that each embedded trace 108 is exposed with respect to the uppermost electrically insulating layer structure 104. Furthermore, each of said traces 108 may be configured so that it comprises, in a cross section, two sharp edges 114 at the exterior surface 112 and one or two rounded edges 116 at an opposed extremity. As already mentioned above, these features are not visible in the schematic illustration of Figure 3 to Figure 8.

Thereafter, the process described referring to Figure 3 to Figure 8 may be repeated from the dielectric application up to the completion of the formation of traces 108 for a next layer. This may be continued until a desired build-up is completed.

**Figure 9** illustrates a cross-sectional image of traces 108 of a component carrier 100 according to an exemplary embodiment of the invention. As shown in Figure 9, traces 108 with very small horizontal width in a range from 3 µm to 4 µm may be obtained by the manufacturing process according to exemplary embodiments.

**Figure 10** illustrates a cross-sectional view of a preform of traces 108 of a component carrier 100 according to an exemplary embodiment of the invention.

More specifically, a plurality of still integrally connected traces 108 are shown in Figure 10, wherein their interconnection is accomplished by an overlapping region 136, as described above referring to Figure 8. Based on the structure shown in Figure 10, a planarizing process such as CMP may be executed for removing material of the overlapping region 136 as well as surface material of the uppermost electrically insulating layer structure 104 so as to separate the individual trenches 108 and form a trace geometry such as the one described above referring to Figure 1.

Several characteristic dimensions are indicated in Figure 10.

**Figure 11** illustrates a three-dimensional view 200, a cross-sectional view 202 and a plan view 204 of traces 108 and (copper filled) embedded trenches 162 of a component carrier 100 according to an exemplary embodiment of the invention. The traces 108 and the embedded trenches 162 may be made of an electrically conductive material and may be interconnected. The traces 108 may extend vertically, whereas the embedded trenches 162 may extend horizontally. The plan view 204 of Figure 11 shows broad trenches 162 with reference sign 206 and shows narrow or small trenches 162 with reference sign 208. When creating the trenches 162 and applying a laser for a longer time on the same position, a connection to the below laying layer can be created. Thereby, a lateral protrusion 210 in the respective trench 162 can be seen in the plan view 204. The vertical connection in form of the traces 108 may have a tapered shape due to the laser process.

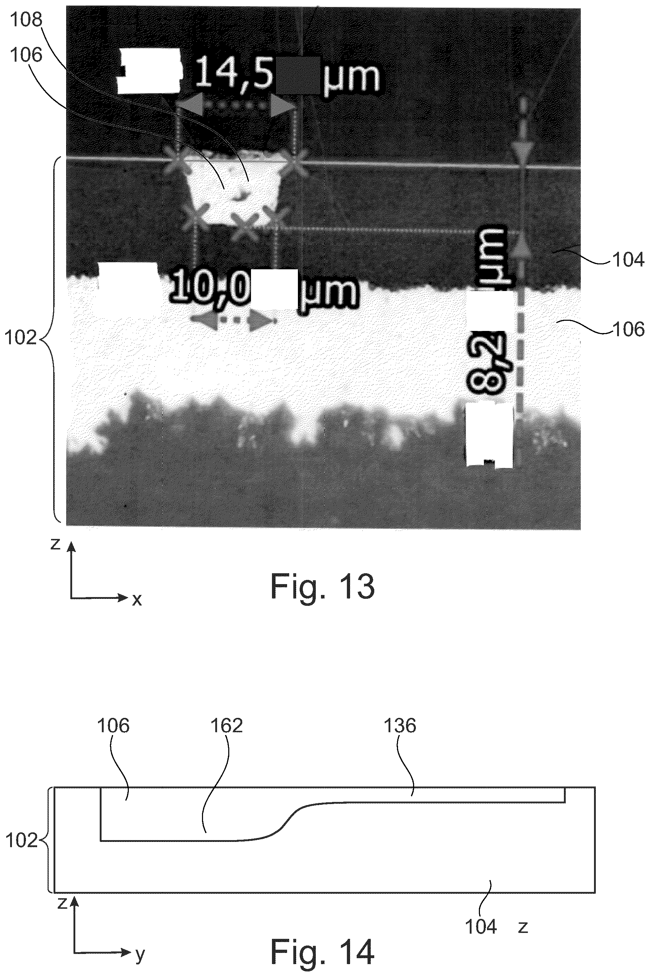

Figure 12 and Figure 13 illustrate cross-sectional images of preforms of traces 108 of a component carrier 100 according to an exemplary embodiment of the invention.

Referring to **Figure 12**, an overview of several still integrally connected traces 108 of a preform of a component carrier 100 is shown, wherein the connection is accomplished by an overlapping region 136. In the embodiment of Figure 12, there is a dimple or shallow recess in the overlapping region due to the fact that more copper is plated in the traces. Thus, the dimple may be created due to the fact that more copper is plated in the recess rather than in a remaining area.

Referring to **Figure 13**, a further enlarged view is shown.

**Figure 14** illustrates a cross-sectional view of a trace 108 of a component carrier 100 according to an exemplary embodiment of the invention. Compared to the other cross sectional views (x-z view), where the width of the traces 108 is shown, in Figure 14 the cross sectional view is in y-z view. The x-z view and the y-z view are shown in Figure 13 and Figure 14, respectively. Therefore, the length of one (in particular copper filled) embedded trench 162 is shown in Figure 14. By variation of the laser parameters, the vertical depth can be adjusted. The left side of the trench 162 is deeper and thus the copper filled in the trench 162 has a bigger cross section compared to the right side. On the right side the trench depth is not that deep. In this way, the geometry of the copper trench 162 can be varied and adjusted very easily. Figure 14 shows the trench 162 embedded in an electrically insulating layer structure 104 and before removal of an overlapping region 136.

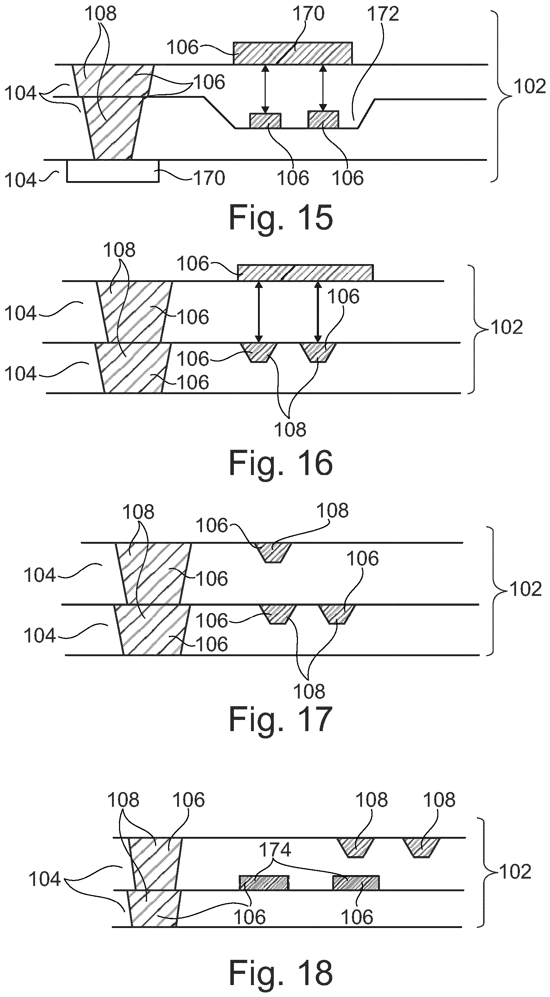

Figure 15 to Figure 19 illustrate cross-sectional views of traces 108 of component carriers 100 according to an exemplary embodiment of the invention. Figure 15 to Figure 19 illustrate the geometry of the traces 108 only schematically. In practice, the traces 108 may have a geometry as shown for instance in Figure 1 or Figure 23.

Referring to **Figure 15**, vertically stacked traces 108 are shown which may also be connected to pads 170. Such pads 170 or traces 108 may also be inserted in a cavity 172 formed in the layer stack 102. Preferably, cavity 172 is created by the laser process similarly used for creating the trenches (for example the above mentioned broad trenches). However, the trench is not fully filled with copper. In this example, copper traces for example created by an additive process (for instance modified semi-additive processing, mSAP) are fully located inside the cavity 172.

Referring to **Figure 16**, vertically stacked traces 108 may be provided together with traces 108 arranged side-by-side. Figure 16 shows a stack 102 having two electrically insulating layer structures 104 stacked one above the other. In one electrically insulating layer structure 104, the bottom layer, embedded traces 108 may be located. The top electrically insulating layer structure 104 may have attached an electrically conductive layer structure 106, in this case a copper pad, which is exposed on one main surface and/or protrudes from outwardly from the stack 102. Optionally, the copper pad and the embedded trace 108 can be connected by a vertical interconnection.

Referring to **Figure 17**, two traces 108 are vertically stacked. The stack 102 comprises two electrically insulating layer structures 104 stacked one above the other. Both of the electrically insulating layer structures 104 may comprise embedded traces 108. In one option, the trace 108 can be vertically aligned one above the other (left side). In another option, the traces 108 in the respective layers can be laterally displaced (right side). This may give the possibility to take the impedances of the traces 108 into consideration during the design of the stack 102 and thus optimize the location of the embedded traces 108 having low losses through cross talk.

Referring to **Figure 18**, traces 108 according to exemplary embodiments may be combined with pads 174 formed on top of an electrically insulating layer structure 104. The stack 102 comprises an electrically insulating layer structure 104 having electrically conductive layer structures 106 inside created by an additive process (for instance mSAP, in the image the bottom electrically conductive layer structures with reference number 174) located on the bottom side of the electrically insulating layer structure 104. In the same electrically insulating layer structure 104, embedded traces 108 may be located on the opposed top side. Both, the traces 108 and trenches are inside the layer structure 104. In one option, trace 108 and electrically conductive layer structure 174 can be vertically aligned one above the other (left trace 108). In another option, trace and trench can be laterally displaced (right trace 108). In an example, the trace 108 can have a different function compared to the electrically conductive layer structure 174. The trace 108 can have a ground function and the electrically conductive layer structure 174 can have a signal function. Alternatively, electrically conductive layer structure 174can have a power function and the trace 108 can have a signal function. This may give the advantage of having a higher copper density inside one electrically insulating layer structure 104 (having two functions inside).

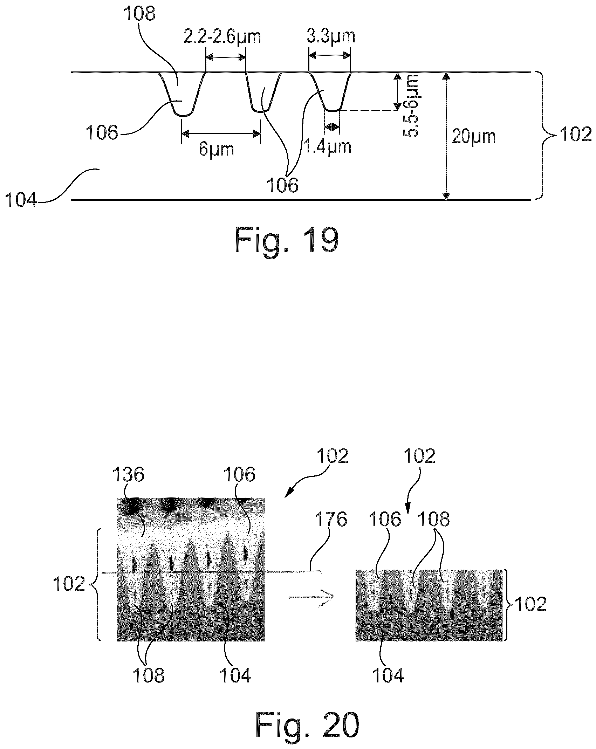

Referring to **Figure 19**, exemplary dimensions of traces 108 according to exemplary embodiments as well as their mutual distances are shown. As can be taken from Figure 19, very small line space L/S ratios may be obtained, for instance not more than 4 µm or less.

**Figure 20** illustrates a cross-sectional image of traces 108 or preforms of traces 108 of component carriers 100 according to exemplary embodiments of the invention. Referring to Figure 20, the left-hand side shows a preform of a component carrier 100 with traces 108 which are still integrally connected by overlapping region 136. A vertical line 176 in this image indicates up to which vertical height a planarizing process (such as a CMP process) may remove metallic and dielectric material from the top region of the layer stack 102 in order to obtain the separate traces 108 as shown on the right-hand side of Figure 20.

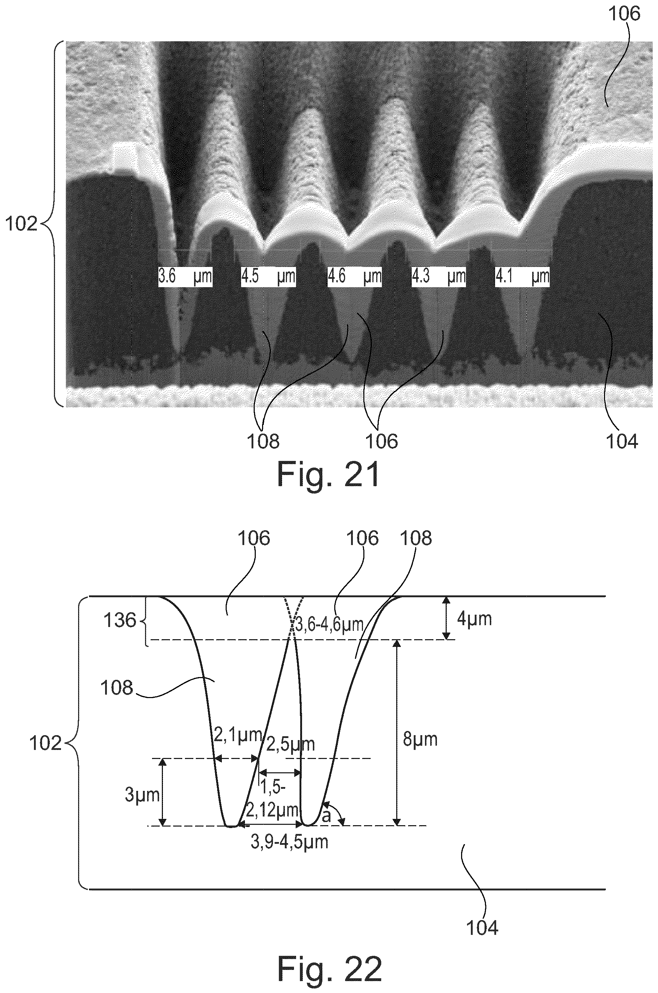

Referring to **Figure 21**, a practical example of a manufactured stack 102 before removal of an overlapping region 136 and thus before separation of individual traces 108 is shown. Figure 21 shows a three-dimensional image. In Figure 21, the seed layer, in this case sputtered metal layer, can be seen before fully filling the trenches with electrically conductive material.

**Figure 22** illustrates a cross-sectional view of a preform of two traces 108 of a component carrier 100 according to an exemplary embodiment of the invention. By CMP, an upper surface portion of the stack 102 of Figure 22 may be removed for separating individual traces 108.

**Figure 23** illustrates a cross-sectional view of a trace 108 of a component carrier 100 according to another exemplary embodiment of the invention. The embodiment of Figure 23 differs from the embodiment according to Figure 1 in particular in that, according to Figure 23, two rounded edges 116 are provided which are connected with each other by a flat portion 150. Hence, two rounded edges 116 are provided according to Figure 23 rather than one common rounded edge 116 as in Figure 1. The shape of the trace 108 with one or two rounded edges 116 may be adjusted by correspondingly setting manufacturing parameters, for instance of a laser process for defining trenches and a plating process for filling the trenches with a metallic material.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A component carrier (100), which comprises:
a stack (102) comprising at least one electrically insulating layer structure (104) and at least one electrically conductive layer structure (106);
said at least one electrically conductive layer structure (106) comprising at least one trace (108) embedded in the at least one electrically insulating layer structure (104);
said at least one trace (108) comprising, in a cross section, two lateral walls (110) slanted inwardly beginning from an exterior surface (112) where said embedded trace (108) is exposed with respect to the at least one electrically insulating layer structure (104);
wherein the at least one trace (108) comprises, in the cross section, two sharp edges (114) at the exterior surface (112) and at least one rounded edge (116) at an opposed extremity.

2. The component carrier (100) according to claim 1, wherein the at least one rounded edge (116) continuously merges into the two slanted lateral walls (110).

3. The component carrier (100) according to any of claims 1 to 2, wherein at least a section of the slanted lateral walls (110) extends substantially straight.

4. The component carrier (100) according to any of claims 1 to 3, wherein, in the cross section, the at least one trace (108) has a trace area (A) in a range from 1 µm² and 25 µm², for example in a range from 6 µm² and 18 µm².

5. The component carrier (100) according to any of claims 1 to 4, wherein the lateral walls (110) of the at least one trace (108) are inclined, beginning from the exterior surface (112), with respect to a stack thickness direction (138) by an inclination angle (β) in a range from 1° and 30°, in particular in a range from 5° to 15°.

6. The component carrier (100) according to any of claims 1 to 5, comprising a plurality of traces (108) arranged side-by-side in the at least one electrically insulating layer structure (104)in particular wherein different ones of the traces (108) have different maximum horizontal widths (D), and/or different inclination angles (β) of the lateral walls (110) at the exterior surface (112), and/or different vertical thickness (L) one to each other.

7. The component carrier (100) according to any of claims 1 to 6, wherein a minimum distance (F) of the at least one rounded edge (116) of the at least one trace (108) from a main surface of an electrically insulating layer structure (104') opposing the exterior surface (112) is at least 0.8 times a maximum horizontal width (D) of the at least one trace (108) and/or is at least 0.8 times a vertical thickness (L) of the at least one trace (108).

8. The component carrier (100) according to any of claims 1 to 7, wherein two embedded traces (108) are misaligned one to each other in a plan view.

9. The component carrier (100) according to any of claims 1 to 8, comprising two components (120, 122) arranged in and/or on said stack (102), wherein at least one trace (108) is configured to connect said two components (120, 122).

10. The component carrier (100) according to any of claims 1 to 9, wherein the at least one electrically insulating layer structure (104) in which the at least one trace (108) is embedded is free of reinforcing fibers.

11. The component carrier (100) according to any of claims 1 to 10, wherein the at least one trace (108) has a turning point (128) arranged between said slanted lateral walls (110) and said at least one rounded edge (116), wherein a curvature of an interface (118) between said at least one trace (108) and the at least one electrically insulating layer structure (104) changes from right curved to left curved.

12. The component carrier (100) according to any of claims 1 to 11, wherein the at least one trace (108) has a turning point (128) arranged between said slanted lateral walls (110) and said sharp edges (114), wherein a curvature of an interface (118) between said at least one trace (108) and the at least one electrically insulating layer structure (104) changes from the turning point (128) to the sharped edge (114).

13. A method of manufacturing a component carrier (100), wherein the method comprises:
forming a stack (102) comprising at least one electrically insulating layer structure (104) and at least one electrically conductive layer structure (106);
forming said at least one electrically conductive layer structure (106) with at least one trace (108) embedded in the at least one electrically insulating layer structure (104);
configuring said at least one trace (108) so that it comprises, in a cross section, two lateral walls (110) slanted inwardly beginning from an exterior surface (112) where said embedded trace (108) is exposed with respect to the at least one electrically insulating layer structure (104); and
configuring said at least one trace (108) so that it comprises, in the cross section, two sharp edges (114) at the exterior surface (112) and at least one rounded edge (116) at an opposed extremity.

14. The method according to claim 13, wherein the method comprises:
forming at least two recesses (134) in the at least one electrically insulating layer structure (104);
filling the at least two recesses (134) and an overlapping region (136) between said at least two recesses (134) with electrically conductive material; and
thereafter removing an excessive part of said electrically conductive material of the overlapping region (136) to thereby separate remaining electrically conductive material to obtain separate at least two traces (108).

15. The method according to claim 14, wherein the method comprises:
forming at least one recess (134) in the at least one electrically insulating layer structure (104) by a laser beam; and
filling the at least one recess (134) with electrically conductive material for forming said at least one trace (108), in particular wherein the method comprises forming the at least one recess (134) by only one laser shot moving along a main surface of the at least one electrically insulating layer structure (104) in accordance with a trajectory of the at least one trace (108) to be formed.
